# EUROPÄISCHE PATENTANMELDUNG

(11) **EP 0 701 281 A2**
(43) Veröffentlichungstag der Anmeldung: **13.03.1996**
(21) Anmeldenummer: 95107941.7
(22) Anmeldetag: 24.05.1995
(51) Int. Cl.: H01L 23/498, H01L 23/532

(54) **Substrat mit bondfähiger Beschichtung**

(30) Priorität: 07.09.1994 DE 4431847
(71) Anmelder: W.C. Heraeus GmbH, D-63450 Hanau (DE)
(72) Erfinder: Herklotz, Günter, Dr., D-63486 Bruchköbel (DE); Frey, Thomas, D-63454 Hanau (DE); Camus, Otto, D-63526 Erlensee (DE); Ullrich, Karl-Heinz, Dr., D-64823 Gross-Umstadt (DE)
(74) Vertreter: Kühn, Hans-Christian

(57) **Zusammenfassung**

Die Erfindung betrifft mit einer goldhaltigen Beschichtung versehene Leiterplatten und dergleichen für das Bonden von Gold-Drähten mit Hilfe des Thermosonic-Verfahrens. Gold läßt sich einsparen, wenn anstelle der üblichen Beschichtung aus Nickel/Gold eine Beschichtung aus Nickel/Palladium/Gold benutzt wird.

## Beschreibung

Die Erfindung betrifft ein Substrat mit bondfähiger metallischer Beschichtung, die eine Nickel enthaltende Schicht und eine die Oberfläche der Beschichtung bildende Gold enthaltende Schicht umfaßt.

Das beschichtete Substrat stellt besonders einen Leiterrahmen ("lead frame") oder eine Leiterplatte mit bondfähiger Oberfläche dar.

Unter Bonden wird allgemein das Kontaktieren von elektronischen Bauelementen bzw. Halbleiterbauteilen mit ihren Trägerwerkstoffen oder Kontaktelementen verstanden. Die Herstellung der Bondverbindungen kann mit Hilfe des Ultraschall-Verfahrens, des Thermokompressions-Verfahrens und des Thermosonic-Verfahrens erfolgen (Galvanotechnik 85 (1994), 1295).

Beschichtete Substrate mit bondfähiger Oberfläche sind bekannt. So wird beispielsweise in Thin Solid Films 41 (1977), 87-103, eine Kombination metallischer Schichten beschrieben, die für das Bonden mit gold-plattierten Kupfer-Leitern durch Thermokompression geeignet ist. Sie besteht aus der Schichtfolge Titan-Palladium-Gold, wobei die Dicke der Gold-Schicht 2 oder 5 Mikrometer beträgt und die Dicke der Titan-Schicht zwischen 0,075 und 0,25 Mikrometer und die der Palladium-Schicht zwischen 0,15 und 0,25 Mikrometer liegt.

JP 60-7161 A betrifft einen löt- und bondbaren Leiterrahmen ("lead frame") aus einer Nickel-Eisen-Legierung, darauf nach Vorbehandlung aus einem sauren Nickel-Bad aufgebrachter dünner Nickel-Schicht und sehr dünnem Überzug aus Gold, Silber, Palladium oder einer Legierung dieser Metalle.

In DE 41 23 911 C wird ein chemisch vernickeltes DCB-Substrat ("Direkt-Copper-Bonding") beschrieben, das durch Bonden mit dünnen Drähten aus Aluminium verbunden werden kann. Die Nickel-Schicht ist vorzugsweise 7 - 15 Mikrometer dick und kann mit einer hauchdünnen, größenordnungsgemäß 0,1 Mikrometer dicken Goldschicht ("flash") überzogen sein, um sie vor Oxidation zu schützen. Das Drahtbonden erfolgt mit Hilfe eines nadelförmigen Bond-Werkzeuges durch Reibschweißen mit Ultraschallunterstützung.

JP 60-7161 A und DE 41 23 911 C sind Beispiele für die Schichtkombination Nickel/Gold, die für Bondanwendungen weit verbreitet ist. Die an dafür geeignete Gold-Schichten gestellten Anforderungen sind hohe Reinheit (≧ 99,9 % Gold), geringe Härte (≦ 78 HV), seidenmatte Oberfläche mit geeigneter Kornstruktur und thermische Belastbarkeit (Galvanotechnik 83 (1992), 813). Die Gold- und Nickel-Schichten können sowohl chemisch (stromlos) als auch galvanisch abgeschieden werden. Eine chemisch-reduktive Gold-Elektrolyt-Kombination zur Herstellung haftfester Gold-Schichten auf Ni-, NiₓP_{y}- und NiₓB_{y}-Oberflächen ist beispielsweise aus DD 299 382 A7 bekannt. Die aus der Elektrolyt-Kombination abgeschiedenen Gold-Schichten sind chip- und drahtbondbar. US 4 154 877 A betrifft zur Abscheidung der Schichtkombination Nickel/Gold geeignete chemische Nickel-Bäder und Gold-Bäder.

Für das Bonden von Aluminium-Feinstdrähten mit Hilfe des Ultraschallverfahrens haben sich 0,05 - 0,2 Mikrometer dicke Gold-Schichten, kombiniert mit 3 - 5 Mikrometer dicken Nickel-Schichten, als besonders geeignet erwiesen. Für das Bonden von Gold-Feinstdrähten mit Hilfe des Thermosonic-Verfahrens sind stärkere Gold-Schichten erforderlich; ihre Dicke liegt im allgemeinen zwischen 0,5 und 2,5 Mikrometer (Galvanotechnik 85 (1994), 1299, 1301).

Es ist die Aufgabe der Erfindung, ein Substrat mit bondfähiger metallischer Beschichtung der eingangs charakterisierten Art zum Bonden von Gold-Feinstdrähten zu finden, das - verglichen mit dem Stand der Technik - dünnere Gold-Schichten, also einen sparsameren Verbrauch an Gold ermöglicht. Hinsichtlich der Reinheit, Härte und Kornstruktur der Gold-Schichten soll eine größere Variation möglich sein, ohne daß die Bondfähigkeit darunter leidet. Das beschichtete Substrat soll insbesondere ein Leiterrahmen und eine Leiterplatte mit bondfähiger Oberfläche sein.

Das die Lösung der Aufgabe darstellende Substrat mit bondfähiger metallischer Beschichtung ist erfindungsgemäß dadurch gekennzeichnet, daß die Beschichtung eine Kombination aus a) einer Nickel- oder Nickellegierungs-Schicht, b) einer Palladium enthaltenden Schicht und c) einer Gold- oder Goldlegierungs-Schicht ist und die Gold- oder Goldlegierungs-Schicht eine Dikke von 0,01 - 0,5 Mikrometer aufweist.

Besonders bewährt hat sich das beschichtete Substrat, wenn die Nickel- oder Nickellegierungs-Schicht eine Dicke von 1 - 10 Mikrometer und die Palladium enthaltende Schicht eine Dicke von 0,01 - 0,5 Mikrometer aufweist.

Bevorzugt werden folgende Schichtdicken:
0,05 - 0,1 Mikrometer für die Gold- oder Goldlegierungs-Schicht,
0,05 - 0,2 Mikrometer für die Palladium enthaltende Schicht und
2 Mikrometer für die Nickel- oder Nickellegierungs-Schicht.

Die Oberfläche der Beschichtung besteht besonders aus Gold (Feingold) oder einer Legierung aus Gold und Eisen, Kobalt oder Nickel (Hartgold mit 98 - 99 Gewichts-% Gold, Härte 140 - 200 HV).

Als Material für die direkt auf dem Substrat befindliche Schicht wird vorzugsweise Nickel oder eine Nickel-Bor-, Nickel-Phoshor-, Nickel-Eisen-Phosphor-, Nickel-Phosphor-Wolfram-, Nickel-Kobalt-Phosphor- oder Nickel-Wolfram-Legierung gewählt.

Für die Bildung der Palladium enthaltenden Schicht eignet sich besonders Palladium, eine Palladium-Nickel-Legierung oder eine Palladium-Silber-Legierung, kombiniert mit einer dünnen Palladium-Schicht, die die Haftung der Palladium-Silber-Legierung auf der Nickel- oder Nickellegierungs-Schicht verstärkt und daher im Sinne der Erfindung als Haft-Palladium bezeichnet wird. Die Schichtdicke des Haft-Palladiums beträgt 0,01 - 0,1 Mikrometer.

Besonders bewährt hat sich als Palladium-Nickel-Legierung eine Legierung aus 60 - 90 Gewichts-% Palladium und 10 - 40 Gewichts-% Nickel und als Palladium-Silber-Legierung eine Legierung aus 50 - 90 Gewichts-% Palladium und 10 - 50 Gewichts-% Silber; bevorzugt werden die Legierungen aus 75 Gewichts-% Palladium und 25 Gewichts-% Nickel und aus 50 Gewichts-% Palladium und 50 Gewichts-% Silber.

Bilden die Schichten die bondfähige Beschichtung eines Leiterrahmens, so besteht das Substrat vorzugsweise aus Kupfer, Kupfer-Legierungen, wie CuFe und CuBe, Nickel oder Nikkel-Legierungen, wie NiFe.

Für den Einsatz des beschichteten Substrats als Leiterplatte mit bondfähiger Oberfläche werden für das Substrat Metall/Kunststoff-Verbundwerkstoffe verwendet, besonders mit Kupfer-Metallisierungen versehene Polyimide und glasfaserverstärkte Epoxidharze.

Auf das aus einem der genannten metallischen Werkstoffe oder Metall/Kunststoff-Verbundwerkstoffe bestehende Substrat werden die die Beschichtung bildenden Schichten in an sich bekannter Weise chemisch (stromlos) oder galvanisch abgeschieden. Dafür geeignete Bäder und Verfahren sind zum Beispiel aus Galvanotechnik 83 (1992), 808 - 817, 84 (1993), 2058 - 2066, und 85 (1993), 1661 - 1666, und EP 0 073 236 B bekannt.

Substrate mit der metallischen Beschichtung gemäß der Erfindung zeichnen sich durch gute Bondeigenschaften beim Bonden von Gold-Feinstdrähten und durch eine im Vergleich zum Stand der Technik reduzierte Schichtdicke der die Oberfläche der Beschichtung bildenden Gold- oder Goldlegierungs-Schicht aus. Das Bonden der Gold-Feinstdrähte erfolgt vorzugsweise mit Hilfe des Thermosonic-Verfahrens in Ball-Wedge-Technik (Galvanotechnik 85 (1994), 1300 und 1301).

Zur näheren Erläuterung werden in den folgenden Beispielen beschichtete Substrate gemäß der Erfindung und - zum Vergleich damit - Substrate mit bekannter Nickel/Gold-Beschichtung beschrieben. Die Bondfähigkeit der beschichteten Substrate wird durch Bestimmung der Abreißkraft von damit verbundenen Bonddrähten geprüft.

### Beispiel 1

Nickel-Schicht, 2 Mikrometer
Palladium-Schicht, 0,1 Mikrometer
Hartgold-Schicht, 0,1 Mikrometer

### Beispiel 2

Nickel-Schicht, 2 Mikrometer
Haft-Palladium, 0,05 Mikrometer
Palladium/Silber-Schicht (50 Gewichts-% Silber), 0,1 Mikrometer
Hartgold-Schicht, 0,1 Mikrometer

### Beispiel 3

Nickel/Phosphor-Schicht, 2 Mikrometer
Palladium-Schicht, 0,1 Mikrometer
Hartgold-Schicht, 0,1 Mikrometer

### Beispiel 4

Nickel/Phosphor-Schicht, 2 Mikrometer
Haft-Palladium, 0,05 Mikrometer
Palladium/Silber-Schicht (50 Gewichts-% Silber), 0,1 Mikrometer
Hartgold-Schicht, 0,1 Mikrometer

### Beispiel 5

Nickel-Schicht, 2 Mikrometer
Palladium/Nickel-Schicht (25 Gewichts-% Nickel), 0,1 Mikrometer
Feingold-Schicht, 0,1 Mikrometer

### Beispiel 6

Nickel-Schicht, 2 Mikrometer
Haft-Palladium, 0,05 Mikrometer
Palladium/Silber-Schicht (50 Gewichts-% Silber), 0,1 Mikrometer
Feingold-Schicht, 0,1 Mikrometer

### Beispiel 7

Nickel-Schicht, 2 Mikrometer
Palladium-Schicht, 0,1 Mikrometer
Feingold-Schicht, 0,1 Mikrometer

### Beispiel 8

Nickel-Schicht, 2 Mikrometer
Palladium-Schicht, 0,07 Mikrometer
Feingold-Schicht, 0,07 Mikrometer

### Beispiel 9 (Vergleich)

Nickel-Schicht, 2 Mikrometer
Hartgold-Schicht, 0,2 Mikrometer

### Beispiel 10 (Vergleich)

Nickel-Schicht, 2 Mikrometer
Feingold-Schicht, 0,1 Mikrometer

### Bestimmung der Abreißkraft

Unter Verwendung der gemäß den Beispielen beschichteten Substrate und von Gold-Bonddrähten mit einem Durchmesser von 25 Mikrometer werden Bondanschlüsse nach dem Thermosonic-Verfahren hergestellt. Die Abreißkraft der Bondanschlüsse wird durch sogenannte Pull-Tests (Pulltester: Precima MCT 15) bestimmt, wobei mittels eines kleinen Hakens bei stereomikroskopischer Betrachtung die Drahtschleife an der Bondstelle abgerissen und die dazu erforderliche Abreißkraft über ein Kraftmeßzelle registriert wird.

Die in jeweils 40 Pull-Tests ermittelten Minimum-, Maximum- und Mittel-Werte der Abreißkraft werden in der Tabelle angegeben. Der Vergleich der Werte zeigt, daß die Bondstellen auf den erfindungsgemäß beschichteten Substraten die größte Haftfestigkeit besitzen.

In der Praxis kommt den Minimum-Werten eine besondere Bedeutung für die Beurteilung der Zuverlässigkeit gebondeter Verbindungen zu. Bei Minimum-Werten unter 5 cN (Centinewton) treten Ausfälle durch Bruch an den Bondstellen auf, wenn die gebondeten Halbleiterbauelemente zum Schutz gegen mechanische und atmosphärische Einflüsse mit Kunststoff umhüllt werden. Bei den beschichteten Substraten gemäß der Erfindung beträgt der niedrigste Minimum-Wert 5,3 cN. Damit ist beim Einspritzen der viskosen Kunststoffpreßmasse eine zuverlässige Haftfestigkeit der Bondstellen gewährleistet.

**Tabelle**

| Beispiel | Abreißkraft [cN] | | |
|---|---|---|---|
| | Minimum | Maximum | Mittel |
| 1 | 6,2 | 9,8 | 8,4 |
| 2 | 6,5 | 10,3 | 8,3 |
| 3 | 5,7 | 10,0 | 8,6 |
| 4 | 6,3 | 10,9 | 8,3 |
| 5 | 7,3 | 10,3 | 9,2 |
| 6 | 5,3 | 12,9 | 8,2 |
| 7 | 6,5 | 9,8 | 8,4 |
| 8 | 6,7 | 9,9 | 8,6 |
| 9 (Vgl.) | 0,2 | 1,8 | 0,8 |
| 10 (Vgl.) | 0,2 | 8,0 | 3,4 |

## Patentansprüche

1. Substrat mit bondfähiger metallischer Beschichtung, die eine Nickel enthaltende Schicht und eine die Oberfläche der Beschichtung bildende Gold enthaltende Schicht umfaßt, dadurch gekennzeichnet, daß die Beschichtung eine Kombination aus a) einer Nickel- oder Nickellegierungs-Schicht, b) einer Palladium enthaltenden Schicht und c) einer Gold- oder Goldlegierungs-Schicht ist und die Gold- oder Goldlegierungs-Schicht eine Dicke von 0,01 - 0,5 Mikrometer aufweist.

2. Substrat mit bondfähiger Beschichtung nach Anspruch 1, dadurch gekennzeichnet, daß die Nickel- oder Nickellegierungs-Schicht eine Dicke von 1 - 10 Mikrometer aufweist.

3. Substrat mit bondfähiger Beschichtung nach Anspruch 1 oder 2, dadurch gekennzeichnet, daß die Palladium enthaltende Schicht eine Dicke von 0,01 - 0,5 Mikrometer aufweist.

4. Substrat mit bondfähiger Beschichtung nach einem der Ansprüche 1 bis 3, dadurch gekennzeichnet, daß die Goldlegierung eine Gold-Eisen-, Gold-Kobalt- oder Gold-Nickel-Legierung ist.

5. Substrat mit bondfähiger Beschichtung nach einem der Ansprüche 1 bis 4, dadurch gekennzeichnet, daß die Nickellegierung eine Nickel-Bor-, Nickel-Phosphor-, Nickel-Eisen-Phosphor-, Nickel-Phosphor-Wolfram-, Nickel-Kobalt-Phosphor- oder Nickel-Wolfram-Legierung ist.

6. Substrat mit bondfähiger Beschichtung nach einem der Ansprüche 1 bis 5, dadurch gekennzeichnet, daß die Palladium enthaltende Schicht aus Palladium besteht.

7. Substrat mit bondfähiger Beschichtung nach einem der Ansprüche 1 bis 5, dadurch gekennzeichnet, daß die Palladium enthaltende Schicht aus einer Palladium-Nickel-Legierung mit 10 - 40 Gewichts-% Nickel besteht.

8. Substrat mit bondfähiger Beschichtung nach einem der Ansprüche 1 bis 5, dadurch gekennzeichnet, daß die Palladium enthaltende Schicht aus einer Palladium-Silber-Legierung mit 10 - 50 Gewichts-% Silber und darunter angeordnetem Haft-Palladium besteht.

9. Substrat mit bondfähiger Beschichtung nach Anspruch 8, dadurch gekennzeichnet, daß die Schichtdicke des Haft-Palladiums 0,01 - 0,1 Mikrometer beträgt.

10. Substrat mit bondfähiger Beschichtung nach einem der Ansprüche 1 bis 9, dadurch gekennzeichnet, daß die Gold- oder Goldlegierungs-Schicht eine Dicke von 0,05 - 0,1 Mikrometer, die Palladium enthaltende Schicht eine Dicke von 0,05 - 0,2 Mikrometer und die Nickel- oder Nickellegierungs-Schicht eine Dicke von 2 Mikrometer aufweist.

11. Substrat mit bondfähiger Beschichtung nach einem der Ansprüche 1 bis 10, dadurch gekennzeichnet, daß das Substrat aus Kupfer, Nickel oder einer Legierung dieser Metalle besteht.

12. Substrat mit bondfähiger Beschichtung nach einem der Ansprüche 1 bis 10, dadurch gekennzeichnet, daß das Substrat aus einem Metall/Kunststoff-Verbundwerkstoff besteht.

13. Substrat mit bondfähiger Beschichtung nach Anspruch 12, dadurch gekennzeichnet, daß das Substrat aus mit einer Kupfer-Metallisierung versehenem Polyimid oder glasfaserverstärktem Epoxidharz besteht.
